**Europäisches Patentamt**

**European Patent Office**

**Office européen des brevets**

(11) Veröffentlichungsnummer: **0 295 440 B1**

# EUROPÄISCHE PATENTSCHRIFT

(45) Veröffentlichungstag der Patentschrift: **22.04.92**

(51) Int. Cl.⁵: **G01R  31/26**

(21) Anmeldenummer: **88107831.5**

(22) Anmeldetag: **16.05.88**

(54) **Verfahren und Messvorrichtung zur Bestimmung der Diffusionslänge der Minoritätsladungsträger zur zerstörungsfreien Detektion von Defekten und Verunreinigungen in Halbleiterkristallkörpern.**

(30) Priorität: **15.06.87 DE 3719921**

(43) Veröffentlichungstag der Anmeldung:
**21.12.88 Patentblatt  88/51**

(45) Bekanntmachung des Hinweises auf die
Patenterteilung:
**22.04.92 Patentblatt  92/17**

(84) Benannte Vertragsstaaten:
**AT BE CH DE ES FR GB IT LI LU NL SE**

(56) Entgegenhaltungen:
**EP-A- 0 120 229**
**DE-A- 3 116 611**
**US-A- 4 205 265**
**US-A- 4 544 887**
**US-A- 4 598 249**

(73) Patentinhaber: **SIEMENS AKTIENGESELL-
SCHAFT
Wittelsbacherplatz 2
W-8000 München 2(DE)**

(72) Erfinder: **Föll, Helmut, Dr.
Wemdingerstrasse 40
W-8000 München 80(DE)**
Erfinder: **Lehmann, Volker, Dipl.-Ing.
Neumarkterstrasse 82a
W-8000 München 80(DE)**

**Beschreibung**

Die Erfindung betrifft ein Verfahren und eine Meßvorrichtung zur Bestimmung der Diffusionslänge der Minoritätsladungsträger und ihrer örtlichen Schwankungen zur zerstörungsfreien Detektion von Defekten und Verunreinigungen in einem Halbleiterkristallkörper.

Es ist bekannt, zur qualitativen Materialcharakterisierung eines Halbleiterkristalls die Diffusionslänge der Minoritätsladungsträger darin zu bestimmen, da sie als Maß für die Zahl der Rekombinationszentren und Haftstellen im Halbleiterkristall gilt. Zur Bestimmung der Diffusionslänge der Minoritätsladungsträger in einem Halbleiterkristall sind zwei Verfahren geläufig, die Photoleitfähigkeitsmessung (Photoconductive decay) und die Messung der Oberflächenphotospannung (Surface Photo Voltage). Beide Verfahren sind aus dem von Tyler G. Hicks und Lester Strong 1975 in USA herausgegebenem Band "Library of Congress Cataloging" in "Publication Data of Texas Instr. Elec. Ser.", S. 105 - 129 bekannt.

Bei der Photoleitfähigkeitsmessung wird der Halbleiter so mit Licht bestrahlt, daß Elektronenlochpaare erzeugt werden und anschließend die Leitfähigkeitsänderung gemessen, aus der die Lebensdauer und damit die Diffusionslänge der Minoritätsladungsträger bestimmt werden kann. Dabei ist die Form des Halbleiterkristalls für die Messung von Bedeutung, so daß vor der Messung der Halbleiterkristall meist zerstört werden muß.

Eine Oberflächenphotospannung entsteht beim Bestrahlen eines Halbleiterkristalls und kann durch kapazitive Kopplung gemessen werden. Die Oberflächenphotospannung kann verwendet werden, um die Diffusionslänge der Minoritätsladungsträger zu messen. Dieses Verfahren ist aus der US-A-4 598 249 bekannt, Aber die Ortsauflösung der Messung ist gering, da die bestrahlte Fläche mindestens 1 cm$^2$ groß sein muß.

Die Erfindung beschreitet einen anderen Weg zur Lösung der Aufgabe, die Diffusionslänge von Minoritätsladungsträgern in einem Halbleiterkristallkörper möglichst genau zu bestimmen.

Die Erfindung ist durch ein Verfahren der eingangs genannten Art dadurch gekennzeichnet, daß

a) der Halbleiterkristallkörper zwischen zwei elektrolytgefüllte Meßhalbkammern gebracht wird, so daß Vorderseite und Rückseite des Halbleiterkristallkörpers jeweils mit dem Elektrolyten einer Meßkammer in Kontakt stehen,

b) der Halbleiterkristallkörper über einen ohmschen Kontakt mit einer Spannungsquelle verbunden wird und eine Spannung zwischen dem Halbleiterkristallkörper und einer Elektrode, der mit der Rückseite des Halbleiterkristallkörpers verbundenen Meßhalbkammer angelegt wird, so daß sich auf der Rückseite des Halbleiterkristallkörpers eine sperrende Raumladungszone ausbildet,

c) die Vorderseite des Halbleiterkristallkörpers mit Licht bestrahlt wird,

d) der bei Bestrahlung auf der Rückseite auftretende Photostrom der Minoritätsladungsträger $I_G$ gemessen wird,

e) eine Spannung zwischen dem Halbleiterkristallkörper und einer Elektrode, der mit der Vorderseite des Halbleiterkristallkörpers verbundenen Meßhalbkammer angelegt wird, so daß sich auf der Vorderseite des Halbleiterkristallkörpers eine sperrende Raumladungszone ausbildet,

f) der bei Bestrahlung auf der Vorderseite des Halbleiterkristallkörpers auftretende Photostrom der Minoritätsladungsträger $I_O$ gemessen wird und

g) mit Hilfe der mathematischen Gleichung

$$I_G/I_O = \frac{\alpha^2 \cdot L^2}{1 - \alpha^2 L^2} \cdot \frac{-2}{\exp(-D/L) + \exp(+D/L)}$$

mit dem Absorptionskoeffizieten $\alpha$ und der Probendicke $D$ die Diffusionslänge $L$ ermittelt wird.

Das Verfahren wird mit Hilfe einer Meßvorrichtung durchgeführt, die gekennzeichnet ist durch

a) zwei durch einen Rahmen gehaltene Meßhalbkammern, die einzeln mit Elektrolyt auffüllbar sind und jeweils eine Elektrode enthalten,

b) eine Haltevorrichtung für den Halbleiterkristallkörper, die so gestaltet ist, daß der Halbleiterkristallkörper zwischen die Meßhalbkammern gebracht werden kann, so daß Vorderseite und Rückseite des Halbleiterkristallkörpers jeweils mit dem Inhalt einer Meßhalbkammer in Kontakt steht,

c) einen Anschluß für das Herstellen eines ohmschen Kontakts zum Halbleiterkristallkörper,

d) mindestens eine Lichtquelle, so daß der Licktstrahl auf die Oberfläche des Halbleiterkristallkörpers gerichtet ist,

e) eine Gleichspannungsquelle zum Anlegen einer Gleichspannung zwischen Halbleiterkristallkörper und Elektrolyt und

f) eine Strommeßvorrichtung.

Weitere Ausgestaltungen und Weiterbildungen der Erfindung gehen aus den Unteransprüchen, sowie nachfolgend aus der anhand der Fig. 1 bis 4 gegebenen Beschreibung hervor.

FIG. 1 zeigt eine schematische Darstellung einer Meßvorrichtung zur Durchführung der erfindungsgemäßen Verfahrens,

FIG. 2 zeigt eine kristalline Halbleiterscheibe mit Verunreinigungen.

FIG. 3 zeigt die Ortsverteilung der Verunreinigungen der Halbleiterscheibe aus Fig. 2.

FIG. 4 zeigt eine schematische Darstellung einer Meßhalbkammer mit Haltevorrichtung für einen Halbleiterkristallkörper.

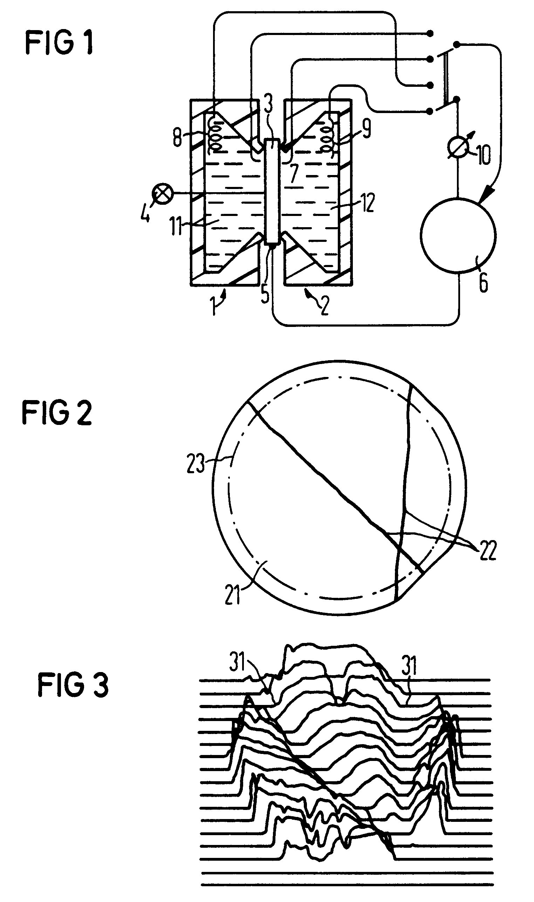

FIG. 1: Zwischen zwei elektrolytgefüllten Meßhalbkammern 1 und 2 befindet sich der Halbleiterkristallkörper 3. Über einen ohmschen Kontakt 5 ist ein Anschluß zwischen dem Halbleiterkristallkörper 3 und der geregelten Gleichspannungsquelle 6 (z.B. Potentiostat) hergestellt. Die Gleichspannung wird zwischen dem ohmschen Kontakt 5 und der Elektrode 9, die sich im Elektrolyten 12 der zweiten Meßhalbkammer 2 befindet, hergestellt. Dabei hat die Rückseite des Halbleiterkristallkörpers 3 Kontakt mit dem Elekrolyten 12 der zweiten Meßhalbkammer 2. Auf der Rückseite des Halbleiterkristallkörpers 3 befindet sich eine oberflächennahe Elektrode 7, die zur Messung der Spannung an der Oberfläche des Halbleiterkristallkörpers 3 dient, so daß mit der gemessenen Spannung die Gleichspannung geregelt werden kann. Die Vorderseite des Halbleiterkristallkörpers 3, die mit dem Elektrolyten 11 der ersten Meßhalbkammer 1 in Kontakt steht, wird mit Laserlicht eines Lasers 4 bestrahlt. Der Lichtstrahl ist mit Hilfe einer Vorrichtung (nicht dargegestellt) so ablenkbar, daß gezielt einzelne Punkte auf der Oberfläche des Halbleiterkristallkörpers 3 bestrahlt werden können. Die Ablenkvorrichtung für den Lichtstrahl kann z.B. aus einer Anordnung von Spiegeln bestehen. Bei der Messung wird die Vorderseite des Halbleiterkristallkörpers 3 mit dem Laserstrahl 4 abgerastert. Die Rastergeschwindigkeit ist typischer Weise 1 bis 100 cm/sec bei einer Fleckgröße von 1mm$^2$. Die Rückseite des Halbleiterkristallkörpers 3 befindet sich im Dunkeln bei der Messung und wird vor der Messung bei n-Silizium positiv und bei p-Silizium negativ gegenüber dem Elektrolyten 12 vorgespannt. Dabei werden typischerweise Gleichspannungen zwischen 2 und 5 Volt gewählt. Der Siliziumelektrolytkontakt verhält sich dann wie eine in Sperrichtung gepolte Diode, d.h. es fließt nur ein kleiner Leckstrom. Zwischen Vorderseite des Halbleiterkristallkörpers 3 und dem Elektrolyten 11 der ersten Meßhalbkammer 1 wird keine Spannung angelegt. Der Elektrolyt 11 dient hier zum Absättigen von Oberflächenzuständen. Der Elektrolyt 11,12 ist in beiden Meßhalbkammern gleich und kann z.B. aus 2%iger Flußsäure bestehen, der einige Tropfen eines Netzmittels beigemischt sind. Vor der Messung kann es eventuell nötig sein, unerwünschte Oberflächenschichten auf dem Halbleiterkristallkörper durch Elektropolieren abzulösen. Die bei Bestrahlung der Vorderseite des Halbleiterkristallkörpers 3 erzeugten Minoritätsladungsträger diffundieren durch den Halbleiterkristallkörper und rekombinieren an etwaigen Rekombinationszentren. Die bis zur Rückseite des Halbleiterkristallkörpers 3 gelangten Ladungsträger werden durch das dort vorhandene elektrische Feld erfaßt und als Photostrom $I_G$ mit Hilfe des Amperemeters 10 gemessen. Vorteilhaft kann sein, einen Lock-in-Verstärker bei der Detektion des Photostroms zu verwenden. Die Größe des auf der Rückseite des Halbleiterkristallkörpers 3 detektierten Photostroms $I_G$ im Verhältnis zum auf der Vorderseite des Halbleiterkristallkörpers erzeugten Photostrom $I_O$ ist ein Maß für die Dichte der Rekombinationszentren des Halbleiterkristallkörpers 3 und ist mit der Minoritätsladungsträgerdiffusionslänge L über die mathematische Gleichung

$$I_G/I_O = \frac{\alpha^2 \cdot L^2}{1 - \alpha^2 L^2} \cdot \frac{-2}{\exp(-D/L) + \exp(+D/L)}$$

verknüpft. Dabei ist D die Dicke des Halbleiterkristallkörpers und $\alpha$ der Absorptionskoeffizient. Die Wiedergabe des Photostroms $I_G$ als Funktion der Koordinaten des auf der Vorderseite einfallenden Laserstrahls ergibt ein Bild der Verteilung der Rekombinationszentren im Volumen des Halbleiterkristallkörpers 3.

Der Photostrom $I_O$ wird gemessen, während eine Gleichspannung zwischen Vorderseite des Halbleiterkristallkörpers 3 und dem Elektrolyten 11 der ersten Meßhalbkammer 1 angelegt wird und die Vorderseite des Halbleiterkristallkörpers bestrahlt wird. Auf der Rückseite des Halbleiterkristallkörpers 3 wird während der Messung von $I_O$ keine Spannung angelegt.

FIG. 2: Auf einer kristallinen Halbleiterscheibe 21 befinden sich zwei Linien einer Eisen-Kontamination 22. Die Linie 23 markiert den Rand der Meßfläche, der durch die geometrischen Maße der Meßhalbkammern 1 und 2 vorgegeben ist.

FIG. 3: Die ortsaufgelöste Messung des Photostroms $I_G$ zeigt an den Stellen, wo sich die Linien einer Eisen-Kontamination 22 auf der kristallinen Halbleiterscheibe 21 befinden, Minima 31.

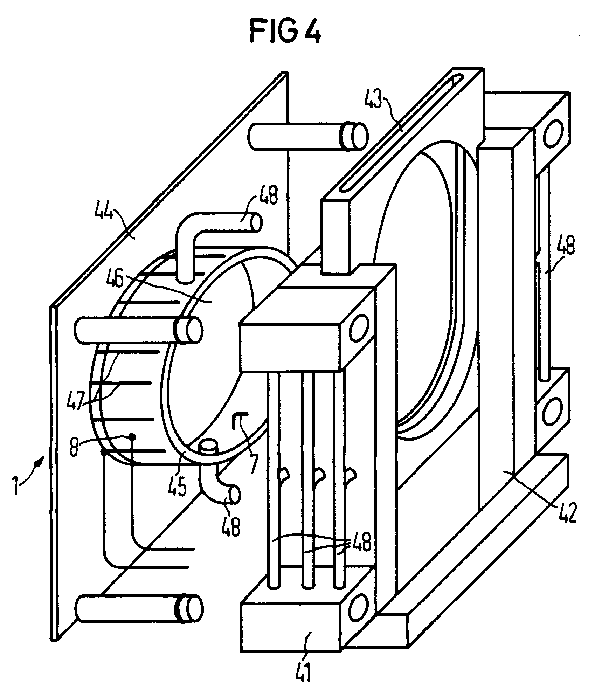

FIG. 4: Die dargestellte Ausführungsform der Meßvorrichtung weist einen zentralen Rahmen 41, eine Haltevorrichtung mit einem Rahmen 42 und einem Adapter 43 für verschiedene Halbleiterkristallkörper und die beiden Meßhalbkammern, von denen nur eine 1 in dieser Figur dargestellt ist, auf. Der Adapter 43 kann Halbleiterkristallkörper mit Durchmessern von 10mm bis 200mm und Dicken von einigen 100 $\mu$m bis zu mehreren Millimetern aufnehmen. Die Trägerplatte 44 der Meßhalbkammer 1 wird mit Hilfe einer Pneumatikvorrichtung (in der Figur nicht dargestellt) so auf den zentralen Rahmen 41 gepreßt, daß die Dichtlippen 45 der Meßhalbkammer 1 fest auf dem Halbleiterkristallkörper haften. Die Dichtlippen 45 der Meßhalbkammer 1 gleichen kleinere Unebenheiten des Halbleiterkristallkörpers aus, so daß dieser weder rund noch vollständig eben sein muß. Die Trägerplatte 44 kann wie der Adapter 43 auf die jeweiligen Halbleiterkristallkörpergröße angepaßt werden. Die äußere Deckplatte 46 der Meßhalbkammer 1 ist optisch transparent und kann auf die Trägerplatte 44 montiert werden. Der gesamte Elektrolyt enthaltende Teil der Meßvorrichtung ist säure-, insbesondere flußsäureresistent und vorzugsweise aus Polyvinylchlorid oder Teflon® hergestellt. Die transparente Deckplatte 46 kann aus Acrylglas oder Quarzglas gefertigt sein, das entweder von Zeit zu Zeit gewechselt wird oder mit einer dünnen Schutzschicht überzogen wurde. Beim Anpressen der Meßhalbkammer 1 auf den Halbleiterkristallkörper wird ein ohmscher Kontakt mit Hilfe des Meßspitzenkranzes 47 hergestellt. Der Meßspitzenkranz 47 kann mit mehreren Meßvorrichtungen versehen sein, so daß damit überprüft werden kann, ob der elektrische Kontakt zum Halbleiterkristallkörper ohmsch ist. Der Meßspitzenkranz 47 kann wahlweise zu dem ohmschen Kontakt 5 verwendet werden. Die Zuleitungen 48 dienen der Zuführung von Elektrolyt, Vakuum und Preßluft.

**Patentansprüche**

1. Verfahren zur Bestimmung der Diffusionslänge (L) der Minoritätsladungsträger und ihrer örtlichen Schwankungen zur zerstörungsfreien Detektion von Defekten und Verunreinigungen in einem Halbleiterkristallkörper, dadurch **gekennzeichnet,** daß

   a) der Halbleiterkristallkörper (3) zwischen zwei elektrolytgefüllte Meßhalbkammern (1,2) gebracht wird, so daß Vorderseite und Rückseite des Halbleiterkristallkörpers (3) jeweils mit dem Elektrolyten (11,12) einer Meßhalbkammer (1,2) in Kontakt stehen,

   b) der Halbleiterkristallkörper (3) über einen ohmschen Kontakt (5) mit einer Spannungsquelle (6) verbunden wird und eine Spannung zwischen dem Halbleiterkristallkörper (3) und einer Elektrode (9) der mit der Rückseite des Halbleiterkristallkörpers (3) verbundenen Meßhalbkammer (2) angelegt wird, so daß sich auf der Rückseite des Halbleiterkristallkörpers (3) eine sperrende Raumladungszone ausbildet,

   c) die Vorderseite des Halbleiterkristallkörpers (3) mit Licht (4) bestrahlt wird,

   d) der bei Bestrahlung auf der Rückseite auftretende Fotostrom der Minoritätsladungsträger $I_g$ gemessen wird,

   e) eine Spannung zwischen dem Halbleiterkristallkörper (3) und einer Elektrode (8) der mit der Vorderseite des Halbleiterkristallkörpers (3) verbundenen Meßhalbkammer (1) angelegt wird, so daß sich auf der Vorderseite des Halbleiterkristallkörpers (3) eine sperrende Raumladungszone ausbildet,

   f) der bei Bestrahlung auf der Vorderseite des Halbleiterkristallkörpers (3) auftretende Fotostrom aller erzeugten Minoritätsladungsträger $I_O$ gemessen wird,

   g) mit Hilfe der mathematischen Gleichung

$$I_G/I_O = \frac{\alpha^2 \cdot L^2}{1 - \alpha^2 L^2} \cdot \frac{-2}{\exp(-D/L) + \exp(+D/L)}$$

   mit dem Absorptionskoeffizienten $\alpha$ und der Probendicke D die Diffusionslänge (L) ermittelt wird.

2. Verfahren nach Anspruch 1, dadurch **gekennzeichnet,** daß zwischen Verfahrensschritt d) und e) die Spannung zwischen dem Halbleiterkristallkörper (3) und den damit in Kontakt stehenden Elektrolyten (12) aufgehoben wird.

3. Verfahren nach Anspruch 1 oder 2, dadurch **gekennzeichnet,** daß die Bestrahlung der Vorderseite des Halbleiterkristallkörpers (3) mit Licht auf der gesamten Fläche erfolgt, so daß mit Hilfe der mathematischen Gleichung die mittlere Diffusionslänge (L) bestimmt wird.

4. Verfahren nach Anspruch 1 oder 2, dadurch **gekennzeichnet, daß** der Halbleiterkristallkörper (3) mit einem punktförmigen Lichtstrahl abgetastet wird, so daß dabei eine ortsaufgelöste Messung erfolgt.

5. Vefahren nach einem der Ansprüche 1 bis 4, dadurch **gekennzeichnet, daß** Laserlicht (4) verwendet wird.

6. Meßvorrichtung zur Bestimmung der Diffusionslänge der Minoritätsladungsträger und ihrer örtlichen Schwankungen zur zerstörungsfreien Detektion von Defekten und Verunreinigungen in einem Halbleiterkristallkörper nach Anspruch 1 **gekennzeichnet** durch
a) zwei durch einen Rahmen (41) gehaltene Meßhalbkammern (1,2), die einzeln mit Elektrolyt (11,12) auffüllbar sind und jeweils eine Elektrode (8,9) enthalten,
b) eine Haltevorrichtung (42) für den Halbleiterkristallkörper (3),die so gestaltet ist, daß der Halbleiterkristallkörper(3) zwischen die Meßhalbkammern (1,2) gebracht werden kann, so daß dessen Vorderseite
und Rückseite jeweils mit dem Inhalt (11,12) einer Meßhalbkammer (1,2) in Kontakt steht,
c) einen Anschluß für das Herstellen eines ohmschen Kontakts (5) zum Halbleiterkristallkörper (3),
d) mindestens eine Lichtquelle (4), so daß der Licktstrahl auf die Oberfläche des Halbleiterkristallkörpers (3) gerichtet ist,
e) eine Gleichspannungsquelle (6) zum Anlegen einer Gleichspannung zwischen Halbleiterkristallkörper (3) und Elektrolyt (11,12) und
f) eine Strommeßvorrichtung (10).

7. Meßvorrichtung nach Anspruch 6, dadurch **gekennzeichnet, daß** sie einen elktrischen Regelkreis (6) enthält, der die am Halbleiterkristallkörper (3) anliegende Gleichspannung konstant hält.

8. Meßvorrichtung nach Anspruch 6 oder 7, dadurch **gekennzeichnet, daß** die Meßhalbkammern (1,2) aus einem säure-, insbesondere flußsäurebeständigen Material bestehen.

9. Meßvorrichtung nach einem der Ansprüche 6 bis 8, dadurch **gekennzeichnet, daß** die Lichtquelle (4) ein Laser ist.

10. Meßvorrichtung nach einem der Ansprüche 6 bis 9, dadurch **gekennzeichnet, daß** sie eine Vorrichtung enthält, mit der der Lichtstrahl ablenkbar ist, so daß er über die Oberfläche des Halbleiterkristallkörpers (3) bewegt werden kann.

11. Meßvorrichtung nach einem der Ansprüche 6 bis 10, dadurch **gekennzeichnet, daß** die Haltevorrichtung aus einem Rahmen (42) und einem Adapter (43) besteht, der verschiedene Halbleiterkristallkörper (3) aufnehmen kann.

12. Meßvorrichtung nach einem der Ansprüche 6 bis 11, dadurch **gekennzeichnet, daß** zum Herstellen eines ohmschen Kontaktes (5) zum Halbleiterkristallkörper (3) mehrere Meßspitzen (47) vorgesehen sind, die auf beiden Seiten des Halbleiterkristallkörpers (3) an mehreren Stellen angeschlossen sind.

**Claims**

1. Method of determining the diffusion length (L) of the minority charge carriers and its positional variations for the nondestructive detection of defects and impurities in a semiconductor crystal body, characterised in that
a) the semiconductor crystal body (3) is placed between two electrolyte-filled measuring chamber halves (1, 2) so that front side and rear side of the semiconductor crystal body (3) are each in contact with the electrolyte (11, 12) of a measuring chamber half (1, 2),
b) the semiconductor crystal body (3) is connected to a voltage source (6) via an ohmic contact (5) and a voltage is applied between the semiconductor crystal body (3) and an electrode (9) of the measuring chamber half (2) connected to the rear side of the semiconductor crystal body (3) so that a blocking space charge zone is formed on the rear side of the semiconductor crystal body (3),

c) the front side of the semiconductor crystal body (3) is irradiated with light (4),

d) the photocurrent of the minority charge carriers $I_g$ occurring on the rear side during irradiation is measured,

e) a voltage is applied between the semiconductor crystal body (3) and an electrode (8) of the measuring chamber half (1) connected to the front side of the semiconductor crystal body (3) so that a blocking space charge zone is formed on the front side of the semiconductor crystal body (3),

f) the photocurrent of all the minority charge carriers $I_0$ occurring on the front side of the semiconductor crystal body (3) during irradiation is measured,

g) the diffusion length (L) is determined with the aid of the mathematical equation

$$I_G/I_0 = \frac{\alpha^2 \cdot L^2}{1 - \alpha^2 L^2} \cdot \frac{-2}{\exp(-D/L) + \exp(+D/L),}$$

where $\alpha$ is the absorption coefficient and D is the specimen thickness.

2. Method according to Claim 1, characterised in that, between method step d) and e) the voltage between the semiconductor crystal body (3) and the electrolytes (12) in contact therewith is removed.

3. Method according to Claim 1 or 2, characterised in that the front side of the semiconductor crystal body (3) is irradiated with light over the entire surface so that the mean diffusion length (L) is determined with the aid of the mathematical equation.

4. Method according to Claim 1 or 2, characterised in that the semiconductor crystal body (3) is scanned with a punctiform light ray so that a positionally resolved measurement takes place in this process.

5. Method according to one of Claims 1 to 4, characterised in that laser light (4) is used.

6. Measuring apparatus for determining the diffusion length of the minority charge carriers and its positional variations for the nondestructive detection of defects and impurities in a semiconductor crystal body according to Claim 1, characterised by

a) two measuring chamber halves (1, 2) which are held by a frame (41) and which can individually be filled with electrolyte (11, 12) and each contain an electrode (8, 9),

b) a holding device (42) for the semiconductor crystal body (3) which is so designed that the semiconductor crystal body (3) can be placed between the measuring chamber halves (1, 2) so that its front side and rear side are each in contact with the contents (11, 12) of a measuring chamber half (1, 2),

c) a terminal for making an ohmic contact (5) to the semiconductor crystal body (3),

d) at least one light source (4) so that the light ray is directed at the surface of the semiconductor crystal body (3),

e) a direct voltage source (6) for applying a direct voltage between semiconductor crystal body (3) and electrolyte (11, 12), and

f) a current measuring apparatus (10).

7. Measuring apparatus according to Claim 6, characterised in that it contains an electrical control circuit (6) which keeps the direct voltage applied to the semiconductor crystal body (3) constant.

8. Measuring apparatus according to Claim 6 or 7, characterised in that the measuring chamber halves (1, 2) are composed of a material which is resistant to acid, in particular resistant to hydrofluoric acid.

9. Measuring apparatus according to one of Claims 6 to 8, characterised in that the light source (4) is a laser.

10. Measuring apparatus according to one of Claims 6 to 9, characterised in that it contains an apparatus with which the light ray can be deflected so that it can be moved across the surface of the semiconductor crystal body (3).

**11.** Measuring apparatus according to one of Claims 6 to 10, characterised in that the holding device is composed of a frame (42) and an adaptor (43) which can receive different semiconductor crystal bodies (3).

**12.** Measuring apparatus according to one of Claims 6 to 11, characterised in that, in order to make an ohmic contact (5) to the semiconductor crystal body (3), a plurality of measuring tips (47) are provided which are connected to both sides of the semiconductor crystal body (3) at a plurality of points.

**Revendications**

**1.** Procédé pour déterminer la longueur de diffusion (L) des porteurs de charges minoritaires et les variations locales de cette longueur pour la détection non perturbée de défauts et d'impuretés dans un corps de cristal semiconducteur, caractérisé par le fait que

a) on dispose le corps de cristal semiconducteur (3) entre deux demi-chambres de mesure (1,2) remplies par un électrolyte de manière que la face avant et la face arrière du corps de cristal semiconducteur (3) soient en contact respectivement avec l'électrolyte (11,12) d'une demi-chambre de mesure (1,2),

b) le corps de cristal semiconducteur (3) est raccordé par l'intermédiaire d'un contact ohmique (5) à une source de tension (6) et une tension est appliquée entre le corps de cristal semiconducteur (3) et une électrode (9) de la demi-chambre de mesure (2) raccordée à la face arrière du corps de cristal semiconducteur (3), de sorte qu'on obtient, sur la face arrière du corps de cristal semiconducteur (3), une zone de charges d'espace réalisant un blocage,

c) on irradie la face avant du corps de cristal semiconducteur (3) par une lumière (4),

d) on mesure le courant photoélectrique formé par les porteurs de charges minoritaires $I_g$, qui apparaît lors de l'irradiation de la face arrière,

e) on applique une tension entre le corps de cristal semiconducteur (3) et une électrode (8) de la demi-chambre de mesure (1) raccordée à la face avant du corps de cristal semiconducteur (3) de manière qu'il se forme une zone de charges d'espace bloquante sur la face avant du corps de cristal semiconducteur (3),

f) on mesure le courant photoélectrique de tous les porteurs de charges minoritaires ($I_O$), qui apparaît lors de l'irradiation de la face avant du corps de cristal semiconducteur (3),

g) on détermine la longueur de diffusion (L) à l'aide de la relation mathématique

$$I_G/I_0 = \frac{\alpha^2 \cdot L^2}{1 - \alpha^2 L^2} \cdot \frac{-2}{\exp(-D/L) + \exp(+D/L)}$$

$\alpha$ désignant le coefficient d'absorption et D l'épaisseur de l'échantillon.

**2.** Procédé suivant la revendication 1, caractérisé par le fait qu'entre les étapes opératoires d) et e), on supprime la tension entre le corps de cristal semiconducteur (3) et l'électrolyte (12) en contact avec ce corps.

**3.** Procédé suivant la revendication 1 ou 2, caractérisé par le fait qu'on exécute l'irradiation de la face avant du corps de cristal semiconducteur (3) avec la lumière sur l'ensemble de la surface de sorte qu'à l'aide de la relation mathématique, on détermine la longueur de diffusion moyenne (L).

**4.** Procédé selon la revendication 1 ou 2, caractérisé en ce qu'on explore le corps de cristal semiconducteur (3) avec un faisceau de lumière ponctuel de manière à réaliser une mesure dans la résolution locale.

**5.** Procédé suivant l'une des revendications 1 à 4, caractérisé par le fait qu'on utilise une lumière laser (4).

**6.** Dispositif de mesure pour déterminer la longueur de diffusion des porteurs de charges minoritaires et ses variations locales pour détecter d'une manière non perturbée des défauts et des impuretés dans un

**EP 0 295 440 B1**

corps de cristal semiconducteur suivant la revendication 1, caractérisé par

a) deux demi-chambres de mesure (1,2), qui sont maintenues par un cadre (41), peuvent être remplies chacune par un électrolyte (11,12) et contiennent chacune une électrode (8,9),

b) un dispositif de maintien pour le corps de cristal semiconducteur (3), qui est agencé de manière qu'on puisse placer le corps de cristal semiconducteur (3) entre les demi-chambres de mesure (1,2) pour que sa face avant et sa face arrière soient respectivement en contact avec le contenu (11,12) d'une demi-chambre de mesure (1,2),

c) une borne pour l'établissement d'un contact ohmique (5) avec le corps de cristal semiconducteur (3),

d) au moins une source de lumière (4) de manière que le faisceau de lumière soit dirigé sur la surface du corps de cristal semiconducteur (3),

e) une source de tension continue (6) pour appliquer une tension continue entre le corps de cristal semiconducteur (3) et l'électrolyte (11,12), et

f) un dispositif de mesure du courant (10).

7. Dispositif de mesure suivant la revendication 6, caractérisé par le fait qu'il comporte un circuit de réglage électrique (6), qui maintient constante la tension continue appliquée au corps de cristal semiconducteur (3).

8. Dispositif de mesure suivant la revendication 6 ou 7, caractérisé par le fait que les demi-chambres de mesure (1,2) sont réalisées en un matériau résistant aux acides, notamment à l'acide fluorhydrique.

9. Dispositif de mesure suivant l'une des revendications 6 à 8, caractérisé par le fait que la source de lumière (4) est un laser.

10. Dispositif de mesure suivant l'une des revendications 6 à 9, caractérisé par le fait qu'il comporte un dispositif, à l'aide duquel on peut dévier le faisceau de lumière de telle sorte qu'il peut être déplacé sur la surface du corps de cristal semiconducteur (3).

11. Dispositif de mesure suivant l'une des revendications 6 à 9, caractérisé par le fait que le dispositif de maintien est constitué par un cadre (42) et un adaptateur (43), qui peut recevoir différents corps de cristal semiconducteur (3).

12. Dispositif de mesure suivant l'une des revendications 6 à 11, caractérisé par le fait que pour établir un contact ohmique (5) avec le corps de cristal semiconducteur (3), il est prévu plusieurs pointes de mesure (47), qui sont raccordées en plusieurs emplacements des deux faces du corps de cristal semiconducteur (3).

8

FIG 1

FIG 2

FIG 3

FIG 4